# EUROPEAN PATENT APPLICATION

(11) **EP 1 077 392 A1**
(43) Date of publication of application: **21.02.2001**
(21) Application number: 00116205.6
(22) Date of filing: 03.08.2000
(51) Int. Cl.: G03F 7/023

(54) **Photosensitive lithographic printing plate**

(30) Priority: 16.08.1999 JP 22988999; 16.08.1999 JP 22989099
(71) Applicant: FUJI PHOTO FILM CO., LTD., Kanagawa 250-01 (JP)
(72) Inventor: Fujita, Kazuo, Yoshida-cho, Haibara-gun, Shizuoka (JP); Tan, Shiro, Yoshida-cho, Haibara-gun, Shizuoka (JP)
(74) Representative: HOFFMANN - EITLE

(57) **Abstract**

A photosensitive lithographic printing plate having a photosensitive layer that comprises an o-naphthoquinone diazide compound and a vinyl polymer insoluble in water but soluble in an alkaline aqueous solution, wherein the vinyl polymer is a copolymer that comprises (A) units of a compound containing at least one phenolic hydroxyl group or at least one sulfonamido group and at least one polymerizable unsaturated bond and (B) units of a compound containing at least one alcoholic hydroxyl group and at least one polymerizable unsaturated bond.

## Description

### FIELD OF THE INVENTION

The present invention relates to a photosensitive lithographic printing plate. More specifically, the present invention is concerned with a photosensitive lithographic printing plate which has a photosensitive layer comprising a positively working photosensitive compound and a high molecular compound having excellent abrasion resistance and chemical resistance, ensures a wide development condition and provides a lithographic printing plate occurring no scum (i.e., no stain)

### BACKGROUND OF THE INVENTION

The photosensitive compositions comprising o-naphthoquinonediazide compounds and novolak type phenol resins have been used industrially as very excellent photosensitive compositions for making lithographic printing plates as well as for photoresist.

However, the novolak type phenol resins used as one of the main constituents have many drawbacks in their properties. For instance, they have poor adhesiveness to substrates, brittleness of their films, inferior coatability and low resistance to abrasion, and cannot ensure sufficient press life for the lithographic printing plates in which they are used, particularly when UV ink is employed for printing, because of their poor resistance to chemicals.

As a method of improving the various properties as mentioned above, the burning-in treatment (heating treatment carried out after development subsequent to exposure) is generally adopted. However, this treatment causes a problem that the low molecular compounds sublimed from the image areas of the photosensitive layer adhere to the non-image areas, and so the resultant printing plate tends to occur scumming (i.e., staining).

In order to solve those problems, various high molecular compounds have been examined for their suitability as binder. For instance, the poly(hydroxystyrene) and hydroxystyrene copolymers disclosed in JP-B-52-41050 (the term "JP-B" as used herein means an "examined Japanese patent publication") can improve film properties, indeed, but have a drawback of being inferior in abrasion resistance and chemical resistance. On the other hand, it is proposed in JP-A-51-34711 (the term "JP-A" as used herein means an "unexamined published Japanese patent application") to use as binders high molecular compounds containing acrylic acid derivatives as their constitutional units. However, those high molecular compounds have a drawback of providing a narrow latitude to the proper development conditions, and besides, imparting insufficient abrasion resistance. Further, the high molecular compounds containing in their molecular structures phenolic hydroxyl group-containing acrylic acid derivative units are proposed as binders in JP-A-63-89864, JP-A-1-35436, JP-A-1-52139 and JP-A-8-339082, but those high molecular compounds are still insufficient in abrasion resistance, and have a problem that the printing plates containing such binders tend to occur scumming.

In addition, the high molecular compounds having sulfonamido groups are proposed as binders in JP-A-2-866, but these compounds also are not yet sufficient in abrasion resistance and tend to cause a scumming problem.

### SUMMARY OF THE INVENTION

Therefore, an object of the present invention is to provide a photosensitive lithographic printing plate that can be developed with an aqueous alkali developer, has excellent abrasion resistance and ensures great press life.

Another object of the present invention is to provide a photosensitive lithographic printing plate that has excellent chemical resistance and can be made into a lithographic printing plate showing a great press life in the printing with UV ink (UV-curable ink) without undergoing burning-in treatment.

Still another object of the present invention is to provide a photosensitive lithographic printing plate that has a wide development condition and can be made into a lithographic printing plate which occurs no scum during printing.

A further object of the present invention is to provide a photosensitive lithographic printing plate comprising a photosensitive layer which has good adhesiveness to a substrate, is a pliable film and has high solubilities in organic solvents.

As a result of our close investigations on the compositions of vinyl copolymers, it has been found that the aforementioned objects are attained with a photosensitive lithographic printing plate using for its photosensitive layer a photosensitive composition which comprises in addition to a photosensitive compound a vinyl polymerization based high molecular compound (abbreviated as "a vinyl polymer" hereinafter) wherein two or more kinds of particular functional groups are present, thereby achieving the present invention.

More specifically, the present invention is embodied in a photosensitive lithographic printing plate having a photosensitive layer that comprises an o-naphthoquinone diazide compound and a vinyl polymer insoluble in water but soluble in an alkaline aqueous solution, wherein the vinyl polymer is a copolymer that comprises (A) units of a compound containing at least one phenolic hydroxyl group or at least one sulfonamido group and at least one polymerizable unsaturated bond (abbreviated as "a monomer (A)" hereinafter) and (B) units of a compound containing at least one alcoholic hydroxyl group and at least one polymerizable unsaturated bond (abbreviated as "a monomer (B)" hereinafter).

By employing a photosensitive composition comprising a copolymer of at least units of a monomer (A) and units of a monomer (B) for its photosensitive layer, the photosensitive lithographic printing plate of the present invention can have satisfactory adhesion between its substrate and the photosensitive layer, the photosensitive layer as a pliable film, a good aptitude for coating on its substrate because of high solubilities of the copolymer in organic solvents, and excellent capability for development with an aqueous alkaline developer in the exposed area formed by coating, drying and then exposing imagewise the photosensitive composition. Further, the relief image formed in the printing plate of the present invention can have high abrasion resistance and good adhesiveness to the substrate, so the printing plate of the present invention having undergone prepress processing can provide a great number of good-quality prints when subjected to printing operations.

In addition, the printing plate of the present invention has excellent chemical resistance, so it can provide a lithographic printing plate having an excellent press life (i.e., a long press life) and occurring no scum even when subjected to the printing with UV ink without undergoing burning-in treatment.

### DETAILED DESCRIPTION OF THE INVENTION

The ingredients of a photosensitive composition used for the photosensitive layer of the photosensitive lithographic printing plate of the present invention are illustrated below in detail.

The present vinyl polymer, which are insoluble in water but soluble in an alkaline aqueous solution, is a high molecular compound prepared by polymerizing at least a monomer (A), comprising a compound containing at least one phenolic hydroxyl group or at least one sulfonamido group and at least one polymerizable unsaturated bond, and a monomer (B), comprising a compound containing at least one alcoholic hydroxyl group and at least one polymerizable unsaturated bond, by using a well-known polymerization initiator in an appropriate solvent.

Suitable examples of the present vinyl polymer, which is insoluble in water but soluble in an alkaline aqueous solution, include acrylate polymers, styrene polymers and vinyl ether polymers.

The compounds containing in each molecule at least one phenolic hydroxyl group and at least one polymerizable unsaturated bond, which are in the monomer (A) category, are represented by the following formula (I₀): 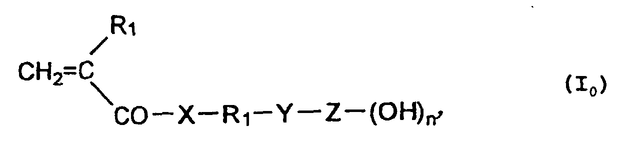 wherein X represents -O- or -NR₃-; R₁ represents -H or -CH₃; R₂ represents an unsubstituted or substituted C₁₋₁₂ alkylene, cycloalkylene, arylene or aralkylene group; R₃ represents a hydrogen atom, or an unsubstituted or substituted C₁₋₁₂ alkyl, cycloalkyl, aryl or aralkyl group; Y represents -NHCOOR₄, -OCONHR₄- or -NHCONHR₄-, R₄ represents a single bond, or an unsubstituted or substituted C₁₋₁₂ alkylene or cycloalkylene group; Z represents an unsubstituted or substituted arylene group; and n' represents a natural number of 1 to 3.

Of the low molecular compounds represented by formula (I₀), the compounds which each contain a C₁₋₈ alkylene group, a cycloalkylene group or a substituted or unsubstituted phenylene or naphthylene group as R₂, a hydrogen atom as R₃ and a single bond or a C₁₋₆ alkylene group as R₄ are preferred in particular. The following compounds (M1) to (M10) are exemplified as examples of low molecular compounds especially preferred in the present invention:

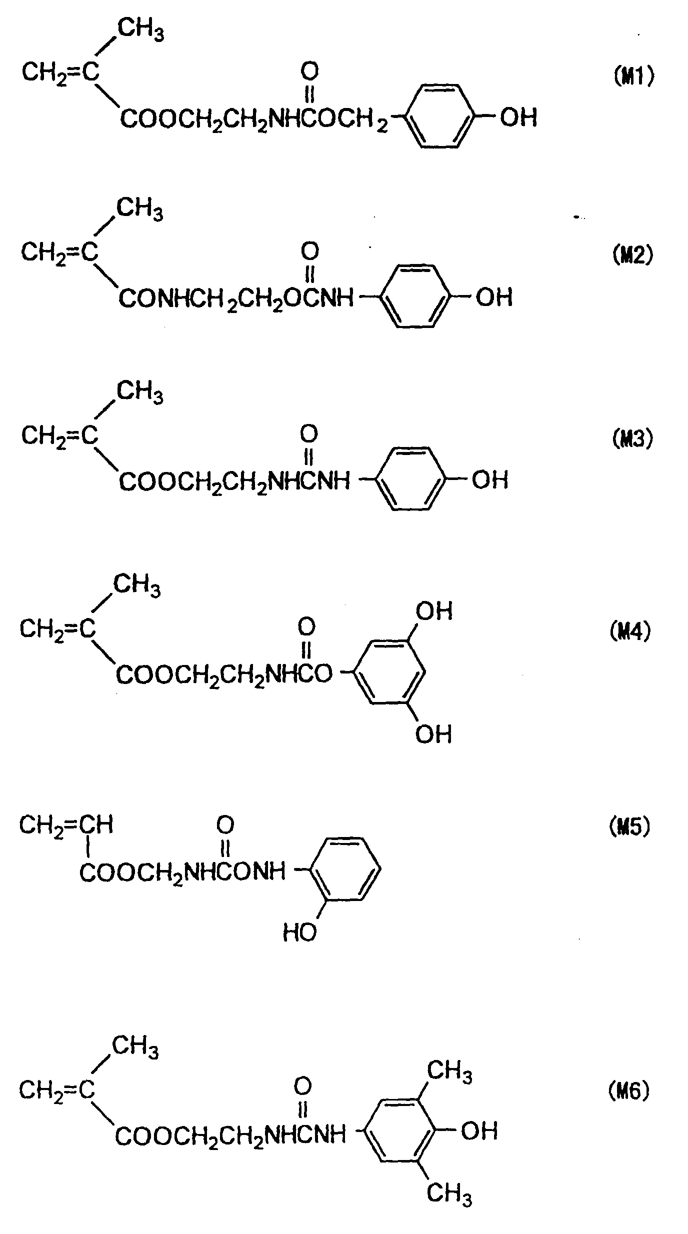

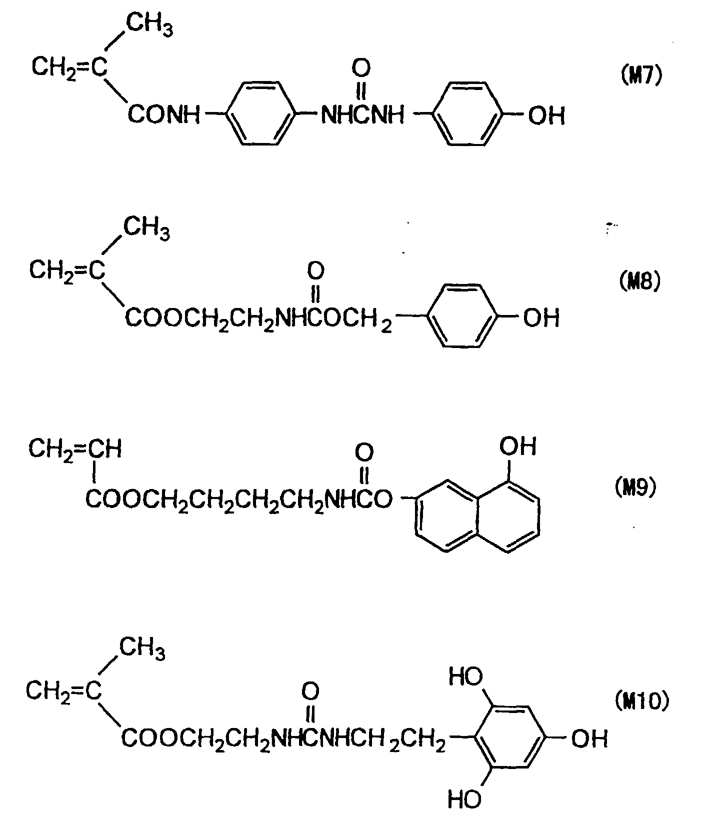

In the present water-insoluble, alkaline aqueous solution-soluble copolymer, the suitable proportion of units of a compound containing at least one phenolic hydroxyl group and at least one polymerizable unsaturated bond (monomer (A) units) is from 1 to 40 mole %, preferably from 10 to 35 mole % in one molecule of the copolymer.

When the proportion of monomer (A) units is smaller than 1 mole %, the resultant copolymer is responsible for failure of development and scumming; while, when it is more than 40 mole %, the resultant copolymer causes the developmental flow or deterioration in press life.

Examples of a compound containing at least one sulfonamido group and at least one polymerizable unsaturated bond, which is also in monomer (A) category, include compounds represented by the following formulae (I) to (V): 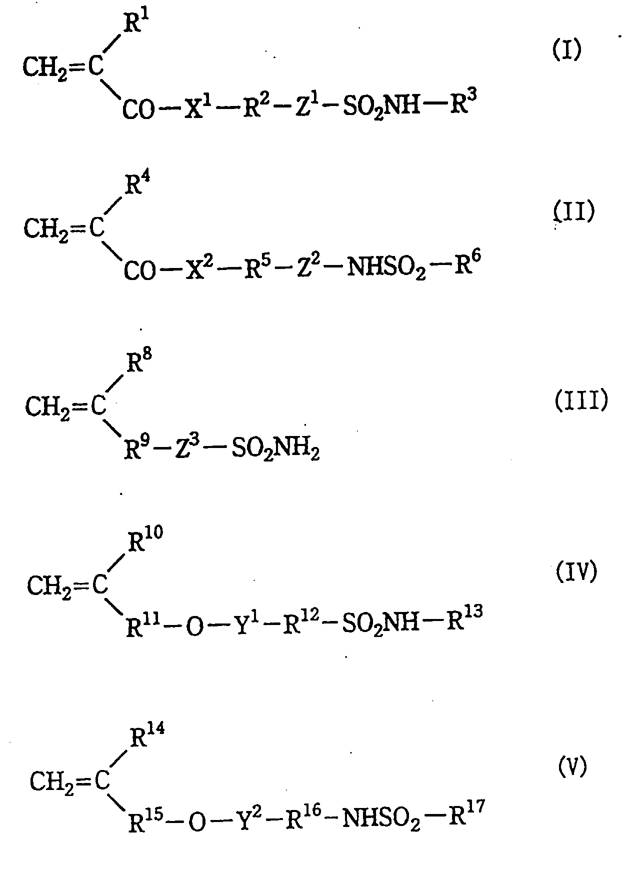 wherein X¹ and X² each represent -O- or -NR⁷-; R¹ and R⁴ each represent -H or -CH₃; R² and R⁵ each represent an unsubstituted or substituted C₁₋₁₂ alkylene, cycloalkylene, arylene or aralkylene group; R³ represents a hydrogen atom, or an unsubstituted or substituted C₁₋₁₂ alkyl, cycloalkyl, aryl or aralkyl group; R⁶ represents an unsubstituted or substituted C₁₋₁₂ alkyl, cycloalkyl, aryl or aralkyl group; R⁷ represents a hydrogen atom, or an unsubstituted or substituted C₁₋₁₂ alkyl, cycloalkyl, aryl or aralkyl group; Z¹, Z² and Z³ each represent a single bond, -NHCOOR¹⁸, -OCONHR¹⁹- or -NHCONHR²⁰-; R¹⁸, R¹⁹ and R²° each represent an unsubstituted or substituted C₁₋₁₂ alkylene, cycloalkylene, arylene or aralkylene group; Y¹ and Y² each represent a single bond or -C (=O)-; R⁸, R¹⁰ and R¹⁴ each represent a hydrogen atom, a halogen atom or a methyl group; R⁹ represents an unsubstituted or substituted C₁₋₁₂ alkylene, cycloalkylene, arylene or aralkylene group; R¹¹ and R¹⁵ each represent a single bond, or an unsubstituted or substituted C₁₋₁₂ alkylene, cycloalkylene, arylene or aralkylene group; R¹² and R¹⁶ each represent an unsubstituted or substituted C₁₋₁₂ alkylene, cycloalkylene, arylene or aralkylene group; R¹³ represents a hydrogen atom, or an unsubstituted or substituted C₁₋₁₂ alkyl, cycloalkyl, aryl or aralkyl group; and R¹⁷ represents an unsubstituted or substituted C₁₋₁₂ alkyl, cycloalkyl, aryl or aralkyl group.

Of the low molecular compounds represented by formula (I) or (II), the compounds particularly suitable for the present invention are those containing as R² and R⁵ each a C₂₋₆ alkylene group, a cyloalkylene group or an unsubstituted or substituted phenylene or naphthylene group, as R³ a hydrogen atom, a C₁₋₆ alkyl group, a cycloalkyl group or an unsubstituted or substituted phenyl or naphthyl group, as R⁶ a C₁₋₆ alkyl group, a cycloalkyl group or an unsubstituted or substituted phenyl or naphthyl group, and as R⁷ a hydrogen atom. Examples of these particularly suitable compounds include methacrylamides, such as N-(o-aminosulfonylphenyl)methacrylamide, N-(m-aminosulfonylphenyl)methacrylamide, N-(p-aminosulfonylphenyl)-methacrylamide, N-(o-methylaminosulfonylphenyl)methacrylamide, N-(m-methylaminosulfonylphenyl)methacrylamide, N-(p-methylaminosulfonylphenyl)methacrylamide, N-(o-ethylamino-sulfonylphenyl)methacrylamide, N-(m-ethylaminosulfonylphenyl)methacrylamide, N-(p-ethylaminosulfonylphenyl)methacrylamide, N-(o-n-propylaminosulfonylphenyl)methacrylamide, N-(m-n-propylaminosulfonylphenyl)methacrylamide, N-(p-n-propylaminosulfonylphenyl)methacrylamide, N-(o-isopropylaminosulfonylphenyl)methacrylamide, N-(m-isopropylaminosulfonylphenyl)methacrylamide, N-(p-isopropylaminosulfonylphenyl)methacrylamide, N-(o-n-butylaminosulfonylphenyl)methacrylamide, N-(m-n-butylaminosulfonylphenyl)methacrylamide, N-(p-n-butylaminosulfonylphenyl)methacrylamide, N-(o-isobutylaminosulfonylphenyl)methacrylamide, N-(m-isobutylaminosulfonylphenyl)methacrylamide, N-(p-isobutylaminosulfonylphenyl)methacrylamide, N-(o-sec-butylaminosulfonylphenyl)methacrylamide, N-(m-sec-butylaminosulfonylphenyl)methacrylamide, N-(p-sec-butylaminosulfonylphenyl)methacrylamide, N-(o-tert-butylaminosulfonylphenyl)methacrylamide, N-(m-tert-butylaminosulfonylphenyl)methacrylamide, N-(p-tert-butylaminosulfonylphenyl)methacrylamide, N-(o-phenylaminosulfonylphenyl)methacrylamide, N-(m-phenylaminosulfonylphenyl)methacrylamide, N-(p-phenylaminosulfonylphenyl)methacrylamide, N-{o-(α-naphthylaminosulfonyl)phenyl}methacrylamide, N-{m-(α-naphthylaminosulfonyl)phenyl}methacrylamide, N-{p-(α-naphthylaminosulfonyl)phenyl}methacrylamide, N-{o-(β-naphthylaminosulfonyl)phenyl}methacrylamide, N-{m-(β-naphthylaminosulfonyl)phenyl}methacrylamide, N-{p-(β-naphthylaminosulfonyl)phenyl}methacrylamide, N-{1-(3-aminosulfonyl)naphthyl}methacrylamide, N-{1-(3-methylaminosulfonyl)naphthyl}methacrylamide, N-{1-(3-ethylaminosulfonyl)naphthyl}methacrylamide, N-(o-methylsulfonylaminophenyl)methacrylamide, N-(m-methylsulfonylaminophenyl)methacrylamide, N-(p-methyl-sulfonylaminophenyl)methacrylamide, N-(o-ethylsulfonylaminophenyl)methacrylamide, N-(m-ethylsulfonylaminophenyl)methyacrylamide, N-(p-ethylsulfonylaminophenyl)methacrylamide, N-(o-phenylsulfonylaminophenyl)methacrylamide, N-(m-phenylsulfonylaminophenyl)methacrylamide, N-(p-phenylsulfonylaminophenyl)methacrylamide, N-{o-(p-methylphenylsulfonylamino)phenyl}methacrylamide, N-{m-(p-methylphenylsulfonylamino)phenyl}methacrylamide, N-{p-(p-methylphenylsulfonylamino)phenyl}methacrylamide, N-{p-(α-naphthylsulfonylamino)phenyl}methacrylamide, N-{p-(β-naphthylsulfonylamino)phenyl}methacrylamide, N-(2-methylsulfonylaminoethyl)methacrylamide, N-(2-ethylsulfonylaminoethyl)methacrylamide, N-(2-phenylsulfonylaminoethyl)methacrylamide, N-(2-p-methylphenylsulfonylaminoethyl)methacrylamide, N-(2-α-naphthylsulfonylaminoethyl)methacrylamide and N-(2-β-naphthylsulfonylaminoethyl)methacrylamide; the acrylamides containing the same substituents as described above; methacrylic acid esters, such as o-aminosulfonylphenyl methacrylate, m-aminosulfonylphenyl methacrylate, p-aminosulfonylphenyl methacrylate, o-methylaminosulfonylphenyl methacrylate, m-methylaminosulfonylphenyl methacrylate, p-methylaminosulfonylphenyl methacrylate, o-ethylaminosulfonylphenyl methacrylate, m-ethylaminosulfonylphenyl methacrylate, p-ethylaminosulfonylphenyl methacrylate, o-n-propylaminosulfonylphenyl methacrylate, m-n-propylaminosulfonylphenyl methacrylate, p-n-propylaminosulfonylphenyl methacrylate, o-i-propylaminosulfonylphenyl methacrylate, m-i-propylaminosulfonylphenyl methacrylate, o-n-butylaminosulfonylphenyl methacrylate, m-n-butylaminosulfonylphenyl methacrylate, p-n-butylaminosulfonylphenyl methacrylate, m-i-butylaminosulfonylphenyl methacrylate, p-i-butylaminosulfonylphenyl methacrylate, m-sec-butylaminosulfonylphenyl methacrylate, p-sec-butylaminosulfonylphenyl methacrylate, m-t-butylaminosulfonylphenyl methacrylate, p-t-butylaminosulfonylphenyl methacrylate, o-phenylaminosulfonylphenyl methacrylate, m-phenylaminosulfonylphenyl methacrylate, p-phenylaminosulfonylphenyl methacrylate, m-(α-naphthylaminosulfonyl)-phenyl methacrylate, p-(α-naphthylaminosulfonyl)phenyl methacrylate, m-(β-naphthylaminosulfonyl)phenyl methacrylate, p-(β-naphthylaminosulfonyl)phenyl methacrylate, 1-(3-aminosulfonyl)naphthyl methacrylate, 1-(3-methylaminosulfonyl)naphthyl methacrylate, 1-(3-ethylaminosulfonyl)naphthyl methacrylate, o-methylsulfonylaminophenyl methacrylate, m-methylsulfonylaminophenyl methacrylate, p-methylsulfonylaminophenyl methacrylate, o-ethylsulfonylaminophenyl methacrylate, m-ethylsulfonylaminophenyl methacrylate, p-ethylsulfonylaminophenyl methacrylate, o-phenylsulfonylaminophenyl methacrylate, m-phenylsulfonylaminophenyl methacrylate, p-phenylsulfonylaminophenyl methacrylate, o-(p-methylphenylsulfonylamino)phenyl methacrylate, m-(p-methylphenylsulfonylamino)phenyl methacrylate, p-(p-methylphenylsulfonylamino)phenyl methacrylate, p(α-naphthylsulonylamino)phenyl methacrylate, p-(β-naphthylsulfonylamino)phenyl methacrylate, 2-methylsulfonylaminoethyl methacrylate, 2-ethylsulfonylaminoethyl methacrylate, 2-phenylsulfonylaminoethyl methacrylate, 2-p-methylphenylsulfonylaminoethyl methacrylate, 2-α-naphthylsulfonylamino-ethyl methacrylate and 2-β-naphthylsulfonylaminoethyl methacrylate; and the acrylic acid esters containing the same substitutents as described above.

As to the substituents preferably present in the low molecular compounds represented by formulae (III) to (V), R⁸, R¹⁰ and R¹⁴ are each a hydrogen atom, R⁹ is an unsubstituted or substituted methylene, phenylene or naphthylene group, R¹¹ and R¹⁵ are each a single bond or a methylene group, R¹² and R¹⁶ are each a C₁₋₆ alkylene group or an unsubstituted or substituted phenylene or naphthylene group, R¹³ is a hydrogen atom, a C₁₋₆ alkyl group, a cycloalkyl group or an unsubstituted or substituted phenyl or naphthyl group, and R¹⁷ is a C₁₋₆ alkyl group, a cycloalkyl group or an unsubstituted or substituted phenyl or naphthyl group.

Sutiable examples of compounds represented by formulae (III) to (V) respectively include p-aminosulfonylstyrene, p-aminosulfonyl-α-methylstyrene, p-aminosulfonylphenyl allyl ether, p-(N-methylaminosulfonyl)phenyl allyl ether, methylsulfonylaminoacetic acid vinyl ester, phenylsulfonylaminoacetic acid vinyl ester, methylsulfonylaminoacetic acid allyl ester, phenylsulfonylaminoacetic acid allyl ester and p-methylsulfonylaminophenyl allyl ether.

In the present water-insoluble, alkaline aqueous solution-soluble copolymer, the suitable proportion of units of a compound containing at least one sulfonamido group and at least one polymerizable unsaturated bond (monomer (A) units) is from 1 to 40 mole %, preferably from 10 to 35 mole % in one molecule of the copolymer.

When the proportion of monomer (A) units is smaller than 1 mole %, the resultant copolymer is responsible for failure of development and scumming; while, when it is more than 40 mole %, the resultant copolymer causes the developmental flow or deterioration in press life.

The alcoholic hydroxyl group of a monomer (B) (or a compound containing at least one alcoholic hydroxyl group and at least one polymerizable unsaturated bond) may be any of primary, secondary and tertiary alcoholic hydroxyl groups, but primary and secondary ones are preferable. The monomer (B) may contain any number of alcoholic hydroxyl groups, but the suitable number of alcoholic hydroxyl group(s) contained therein is from 1 to 3. As examples of a polymerizable unsaturated bond-containing moiety in the monomer (B) , mention may be made of acryl group, styryl group and vinyl group. Preferably, one of such groups is contained in the monomer (B) More specifically, the compounds represented by the following formulae (VI) to (IX) are suitable for the monomer (B): 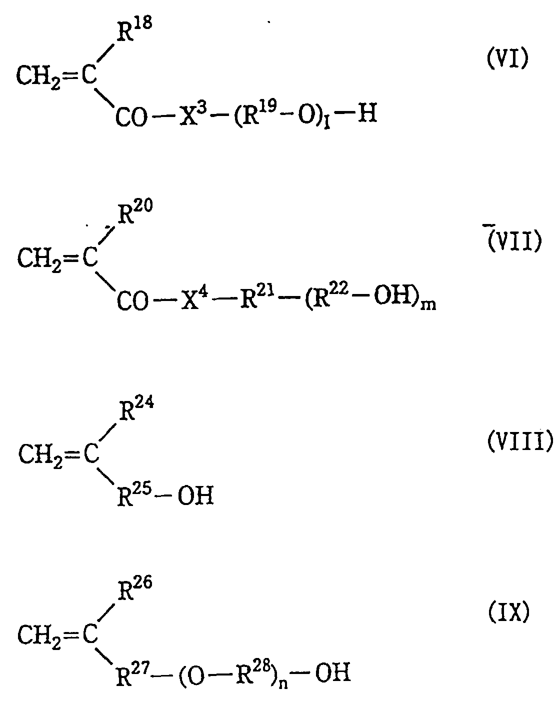 wherein X³ and X⁴ each represent -O- or -NR²³-; R¹⁸ and R²⁰ each represent -H or -CH₃; R¹⁹ and R²² each represent an unsubstituted or substituted C₁_₁₂ alkylene, cycloalkylene or aralkylene group; R²¹ represents a hydrocarbon residue containing at least 2 carbon atoms, wherein a hetero atom may be contained; R²³ represents a hydrogen atom, or an unsubstituted or substituted C₁₋₁₂ alkyl, cycloalkyl, aryl or aralkyl group; R²⁴ and R²⁶ each represent a hydrogen atom, a halogen atom or a methyl group; R²⁵ represents a single bond, or an unsubstituted or substituted C₁₋₁₂ alkylene, cycloalkylene or aralkylene group; R²⁷ represents a single bond, or an unsubstituted or substituted C₁₋₁₂ alkylene, cycloalkylene, arylene or aralkylene group; R²⁸ represents an unsubstituted or substituted C₁₋₁₂ alkylene, cycloalkylene or aralkylene group; and l, m and n each represent an integer of from 1 to 20.

Of the low molecular compounds represented by formulae (VI) and (VII), the compounds particularly suitable for the present invention are those having as R¹⁹ and R²² each a C₁_₆ alkylene group or a cycloalkylene group, as R^{2¹} a C₂₋₆ alkylene group, a cycloalkylene group or an unsubstituted or substituted phenylene or naphthylene group, as R²³ a hydrogen atom, as 1 an integer of 1 to 10 and as m an integer of 1 to 3. Examples of those compounds include acrylic acid esters, such as hydroxymethyl acrylate, 2-hydroxyethyl acrylate, 3-hydroxypropyl acrylate, 4-hydroxybutyl acrylate, 5-hydroxypentyl acrylate, 3-hydroxypentyl acrylate, 2,2-dimethylhydroxypropyl acrylate, trimethylolpropane monoacrylate, diethylene glycol monoacrylate, tetraethylene glycol monoacrylate and dipropylene glycol monoacrylate; methacrylic acid esters, such as hydroxymethyl methacrylate, 2-hydroxyethyl methacrylate, 3-hydroxypropyl methacrylate, 4-hydroxybutyl methacrylate, 5-hydroxypentyl methacrylate, 3-hydroxypentyl methacrylate, 2,2-dimethylhydroxypropyl methacrylate, trimethylolpropane monomethacrylate, diethylene glycol monomethacrylate, tetraethylene glycol monomethacrylate and dipropylene glycol monomethacrylate acrylamides, such as N-hydroxymethylacrylamide, N-(2-hydroxyethyl)acrylamide, N-(3-hydroxypropyl)acrylamide, N-(4-hydroxybutyl)acrylamide, N-(5-hydroxypentyl)acrylamide, N-(3-hydroxypentyl)acrylamide and N-(2,2-dimethylhydroxypropyl)acrylamide; and methacrylamides, such as N-hydroxymethylmethacrylamide, N-(2-hydroxyethyl)methacrylamide, N-(3-hydroxypropyl)methacrylamide, N-(4-hydroxybutyl)methacrylamide, N-(5-hydroxypentyl)methacrylamide, N-(3-hydroxypentyl)methacrylamide and N-(2,2-dimethylhydroxypropyl)methacrylamide.

Of the low molecular compounds represented by formulae (VIII) and (IX), the compounds particularly suitable for the present invention are those having as R²⁴ and R²⁶ each a hydrogen atom, as R²⁵ a single bond, an unsubstituted or substituted methylene group or a C₇₋₁₂ aralkylene group, as R²⁷ a single bond, a methylene group or an unsubstituted or substituted phenylene or naphthylene group, as R²⁸ a C₁₋₆ alkylene group, and as "n" an integer of 1 to 10.

Suitable examples of compounds represented by formulae (VIII) and (IX) include p-hydroxymethylstyrene, m-hydroxyethyl-α-methylstyrene, vinyl alcohol, hydroxyethyl vinyl ether, diethylene glycol vinyl ether and hydroxyethyl allyl ether.

In the present copolymer, the suitable proportion of units of a compound containing at least one alcoholic hydroxyl group and at least one polymerizable unsaturated bond (monomer (B) units) is from 1 to 50 mole %, preferably from 5 to 30 mole %.

When the proportion of monomer (B) units is smaller than 1 mole %, the resultant copolymer is responsible for failure of development and scumming; while, when it is more than 50 mole %, the resultant copolymer causes the developmental flow.

Although the high molecular compound of the present invention may be a copolymer of (A) units of at least one compound containing at least one phenolic hydroxyl or sulfonamido group and at least one polymerizable unsaturated bond and (B) units of at least one compound containing at least one alcoholic hydroxyl group and at least one polymerizable unsaturated bond, the high molecular compound is preferably a copolymer of (A), (B) and (C) units of at least one compound having at least one polymerizable unsaturated bond and containing neither phenolic hydroxyl group, nor sulfonamido group, nor alcoholic hydroxyl group (abbreviated as "monomer (C)" hereinafater).

The monomer (C) is a polymerizable unsaturated compound selected from among, e.g., acrylic acid, methacrylic acid, acrylic acid esters, acrylamides, methacrylic acid esters, methacrylamides, allyl compounds, vinyl ethers, vinyl esters, styrenes or crotonic acid esters.

Examples of an acrylic acid ester usable as a monomer (C) include alkyl acrylates (the alkyl moiety of which preferably contains 1 to 10 carbon atoms), such as methyl acrylate, ethyl acrylate, propyl acrylate, butyl acrylate, amyl acrylate, ethylhexyl acrylate, octyl acrylate, t-octyl acrylate, chloroethyl acrylate, pentaerythritol monoacrylate, glycidyl acrylate, benzyl acrylate, methoxybenzyl acrylate, furfuryl acrylate and tetrahydrofurfuryl acrylate; and aryl acrylates, such as phenyl acrylate. Examples of a methacrylic acid ester usable as a monomer (C) include alkyl methacrylates (the alkyl moiety of which preferably contains 1 to 10 carbon atoms), such as methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl monomethacrylate, glycidyl methacrylate, furfuryl methacrylate and tetrahydrofurfuryl methacrylate; and aryl methacrylates, such as phenyl methacrylate, cresyl methacrylate and naphthyl methacrylate. Examples of an acrylamide usable as a monomer (C) include acrylamide, N-alkylacrylamides (the alkyl moieties of which are alkyl groups having 1 to 10 carbon atoms, such as methyl, ethyl, propyl, butyl, t-butyl, heptyl, octyl, cyclohexyl, hydroxyethyl and benzyl groups), N-arylacrylamides (as the aryl moieties, for example, phenyl, tolyl, nitrophenyl, naphthyl and hydroxyphenyl groups are exemplified), N,N-dialkylacrylamides (as the alkyl moieties, for example, C₁₋₁₀ alkyl groups, such as methyl, ethyl, butyl, isobutyl, ethylhexyl and cyclohexyl groups are exemplified), N,N-diarylacrylamides (as the aryl moieties, for example, phenyl groups are exemplified), N-methyl-N-phenylacrylamide and N-2-acetamidoethyl-N-acetylacryl-amide. Examples of a methacrylamide usable as a monomer (C) include methacrylamide, N-alkylmethacrylamides (as the alkyl moieties, for example, C₁₋₁₀ alkyl groups, such as methyl, ethyl, t-butyl, ethylhexyl, hydroxyethyl and cyclohexyl groups are exemplified), N-arylmethacrylamides (as the aryl moieties, for example, a phenyl group is exemplified), N,N-dialkylmethacrylamides (as the alkyl moieties, for example, C₁₋₁₀ alkyl groups, such as ethyl, propyl and butyl groups are exemplified), N,N-diarylmethacrylamides (as the aryl moieties, for example, e.g., phenyl groups are exemplified), N-methyl-N-phenylmethacrylamide and N-ethyl-N-phenylmethacrylamide. Examples of an allyl compound usable as a monomer (C) include allyl esters (such as allyl acetate, allyl caproate, allyl caprate, allyl laurate, allyl palmitate, allyl stearate, allyl benzoate, allyl acetoacetate and allyl lactate) and allyloxyethanol. Examples of a vinyl ethers usable as a monomer (C) include alkyl vinyl ethers (such as hexyl vinyl ether, octyl vinyl ether, decyl vinyl ether, ethylhexyl vinyl ether, methoxyethyl vinyl ether, ethoxyethyl vinyl ether, chloroethyl vinyl ether, 1-methyl-2,2-dimethylpropyl vinyl ether, 2-ethylbutyl vinyl ether, dimethylaminoethyl vinyl ether, diethylaminoethyl vinyl ether, butylaminoethyl vinyl ether, benzyl vinyl ether, tetrahydrofurfuryl vinyl ether), and vinyl allyl ether (such as vinyl phenyl ether, vinyl tolyl ether, vinylchlorophenyl ether, vinyl-2,4-dichlorophenyl ether, vinyl naphthyl ether and vinyl anthranil ether). Examples of a vinyl ester usable as a monomer (C) include vinyl butyrate, vinyl isobutyrate, vinyl trimethylacetate, vinyl diethylacetate, vinyl valerate, vinyl caproate, vinyl chloroacetate, vinyl dichloroacetate, vinyl methoxyacetate, vinyl butoxyacetate, vinyl phenylacetate, vinyl acetoacetate, vinyl lactate, vinyl β-phenylbutyrate, vinyl cyclohexylcarboxylate, vinyl benzoate, vinyl salicylate, vinyl chlorobenzoate, vinyl tetrachloro-benzoate and vinyl naphthoate. Examples of a styrene usable as a monomer (C) include styrene, alkylstyrenes (such as methylstyrene, dimethylstyrene, trimethylstyrene, ethyl-styrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene and acetoxymethylstyrene), alkoxystyrenes (such as methoxystyrene, 4-methoxy-3-methylstyrene and dimethoxystyrene) and halostyrenes (such as chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene, 4-fluoro-3-trifluoromethylstyrene). Examples of a crotonic acid ester usable as a monomer (C) include alkyl crotonates (such as butyl crotonate, hexyl crotonate and glycerine monocrotonate). Examples of other compounds usable as a monomer (C) include dialkyl itaconates (such as dimethyl itaconate, diethyl itaconate and dibutyl itaconate), dialkyl maleates (such as dimethyl maleate), dialkyl fumarates (such as dibutyl fumarate), acrylonitrile and methacrylonitrile.

Of the polymerizable unsaturated bond-containing compounds described above, methacrylates, acrylates, methacrylamides, acrylamides, acrylonitrile, methacrylonitrile, methacrylic acid and acrylic acid are preferred over the others. In particular, acrylonitrile and methacrylonitrile are used to advantage.

The present copolymer of at least one compound having a polymerizable unsaturated bond as described above, (A) at least one compound containing at least one phenolic hydroxyl or sufonamido group and (B) at least one compound containing at least one alcoholic hydroxyl group may be any of block, random and graft copolymers.

Suitable examples of a solvent used in synthesizing such a high molecular compound by vinyl polymerization include ethylene dichloride, cyclohexanone, methyl ethyl ketone, acetone, methanol, ethanol, ethylene glycol monomethyl ether, ethylene glycol monoethyl ether, 2-methoxyethyl acetate, 1-methoxy-2-propanol, 1-methoxy-2-propylacetate, N,N-dimethylformamide, N,N-dimethylacetamide, dimethyl sulfoxide, toluene, ethyl acetate, methyl lactate and ethyl lactate.

These solvents may be used alone or as a mixture of two or more thereof.

The suitable molecular weight of the high molecular compound of the present invention is on the weight average at least 2,000 and on the number average at least 1,000, preferably on the weight average from 5,000 to 300,000 and on the number average from 2,000 to 250,000. And the preferable degree of polydispersion (weight average molecular weight/number average molecular weight ratio) is at least 1, more preferably from 1.1 to 10.

Additionally, the high molecular compound used in the present invention may contain monomers remaining without undergoing polymerization. In this case, the permissible content of such monomers is 15 weight % or less.

The high molecular compounds according to the present invention may be used alone or as a mixture of two or more thereof.

The suitable content of these high molecular compounds in the photosensitive layer (composition) of the photosensitive lithographic printing plate is from about 5 to about 95 weight %, preferably from about 10 to about 85 weight %.

An example of an o-naphthoquinonediazide compound suitably used in the present invention is the ester of 1,2-diazonaphthoquinonesulfonic acid chloride and pyrogallol-acetone resin as disclosed in JP-A-43-28403.

Another example of an o-naphthoquinonediazide compound suitably used in the present invention is the ester of 1,2-diazonaphthoquinonesulfonic acid chloride and phenolformaldehyde resin as described in U.S. Patents 3,046,120 and 3,188,210. Other useful o-naphthoquinonediazide compounds are disclosed in a large number of published patent applications. For example, the o-naphthoquinonediazide compounds disclosed in JP-A-47-5303, JP-A-48-63802, JP-A-48-63803, JP-A-48-96575, JP-A-49-38701, JP-A-48-13354, JP-A-37-18015, JP-A-41-11222, JP-A-45-9610, JP-B-49-17481, U.S. Patent Nos. 2,797,213, 3,454,400, 3,544,323, 3,573,917, 3,674,495 and 3,785,825, British Patent Nos. 1,227,602, 1,251,345, 1,267,005, 1,329,888 and 1,330,932, and German Patent 854,890 are useful for the present invention.

The o-naphthoquinonediazide compounds used to particular advantage in the present invention are compounds prepared by the reaction of polyhydroxy compounds having molecular weight of 1,000 or less with 1,2-diazonaphthoquinonesulfonic acid chloride. Examples of such reaction products include the compounds disclosed in JP-A-51-139402, JP-A-58-150948, JP-A-58-203434, JP-A-59-165053, JP-A-60-121445, JP-A-60-134235, JP-A-60-163043, JP-A-61-118744, JP-A-62-10645, JP-A-62-10646, JP-A-62-153950, JP-A-62-178562, JP-A-62-233292, and U.S. Patent Nos. 3,102,809, 3,126,281, 3,130,047, 3,148,983, 3,184,310, 3,188,210 and 4,639,406.

In the preparation of the o-naphthoquinonediazide compound as described above, it is appropriate to use 1,2-diazonaphthoquinonesulfonic acid chloride in an amount of 0.2 to 1.2 equivalents, preferably 0.3 to 1.0 equivalent, to the hydroxyl groups in a polyhydroxy compound to react therewith.

The product obtained by the foregoing reaction is a mixture of o-naphthoquinonediazide compounds differing in position and number of the 1,2-diazonaphthoquinonesulfonate groups introduced. In this mixture, the suitable proportion of the compound formed by conversion of all the hydroxyl groups of a polyhydroxy compound into 1,2-diazonaphthoquinone sulfonate groups (namely the completely esterified compound) is at least 5 mole %, preferably from 20 to 99 mole %.

The suitable proportion of o-naphthoquinonediazide compounds in the photosensitive layer of the present photosensitive lithographic printing plate is from 5 to 50 % by weight, preferably from 15 to 40 % by weight.

Besides containing the present high molecular compounds, the photosensitive layer of the present photosensitive lithographic printing plate can contain well-known alkali-soluble high molecular compounds, such as phenol-formaldehyde resin, cresol-formaldehyde resins (e.g., m-cresol-formaldehyde resin, p-cresol-formaldehyde resin, m-/p-cresol mixture-formalde-hyde resin, phenol/cresol (m-cresol, p-cresol or m-/p-cresol mixture) mixture-formaldehyde resin) phenol modified xylene resin, poly(hydroxystyrene) and poly(halogenated hydroxy-styrene).

Of the alkali-soluble high molecular compounds described above, the favorable compounds are those having a weight average molecular weight of from 500 to 20,000 and a number average molecular weight of from 200 to 60,000.

Such alkali-soluble high molecular compounds are used in a proportion of 70 % by weight or less to the total ingredients in the photosensitive layer.

The use of condensation products of phenols having C₃₋₈ alkyl substituents and formaldehyde, such as t-butylphenyl-formaldehyde resin and octylphenol-formaldehyde resin, in combination with those alkali-soluble high molecular compounds is effective in increasing the ink-receptivity of images, as described in U.S. Patent 4,123,279.

To the photosensitive composition used for the present photosensitive lithographic printing plate, it is desirable to add cyclic acid anhydrides, phenols or/and organic acids for the purpose of increasing the photosensitivity thereof.

Examples of a cyclic acid anhydride usable for such a purpose include, as disclosed in U.S. Patent 4,115,128, phthalic anhydride, tetrahydrophthalic anhydride, hexahydrophthalic anhydride, 3,6-endooxy- Δ ⁴-tetrahydrophthalic anhydride, tetrachlorophthalic anhydride, maleic anhydride, chloromaleic anhydride, α-phenylmaleic anhydride, succinic anhydride and pyromellitic anhydride.

Examples of a phenol usable for the foregoing purpose include bisphenol A, p-nitrophenol, p-ethoxyphenol, 2,3,4-trihydroxybenzophenone, 4-hydroxybenzo-phenone, 2,4,4'-trihydroxybenzophenone, 4,4,4''-trihydroxy-triphenylmethane and 4,4',3'',4''-tetrahydroxy-3,5,3',5'-tetramethyltriphenyl-methane.

As to organic acids usable for the foregoing purpose, JP-A-60-88942 and JP-A-2-96755 disclose sulfonic acids, sulfinic acid, alkylsulfates, phosphonic acids, phosphinic acids, phosphates and carboxylic acids. Examples of such acids include p-toluenesulfonic acid, dodecylbenzenesulfonic acid, p-toluenesulfinic acid, ethyl sulfate, phenylphosphonic acid, phenylsulfinic acid, phenyl phosphate, diphenyl phosphate, benzoic acid, isophthalic acid, adipic acid, p-toluylic acid, 3,4-dimethoxybenzoic acid, phthalic acid, terephthalic acid, 1,4-cyclohexene-2,2-dicarboxylic acid, erucic acid, lauric acid, n-undecanoic acid and ascorbic acid.

The suitable proportion of cyclic acid anhydrides, phenols or/and organic acids in the photosensitive composition is from 0.05 to 15 % by weight, preferably from 0.1 to 15 % by weight.

To the photosensitive layer of the photosensitive lithographic printing plate of the present invention, the nonionic surfactants as disclosed in JP-A-62-251740 and JP-A-4-68355 or/and the amphoteric surfactants as disclosed in JP-A-59-121044 and JP-A-4-13149 can also be added with the intention of widening development latitude. Examples of such nonionic surfactants include sorbitan tristearate, sorbitan monopalmitate, sorbitan trioleate, stearic acid monoglyceride, polyoxyethylene-sorbitan monooleate, polyoxyethylene nonyl phenyl ether, and examples of such amphoteric surfactants include alkyldi(aminoethyl)glycine, alkylpolyaminoethylglycine hydrochloride, N-tetradecyl-N,N-betaine type surfactant "Amorgen K" (trade name, a product of Sanyo Chemical Industries Co., Ltd.), 2-alkyl-N-carboxyethyl-N-hydroxyethylimidazolinium betaine, and alkylimidazoline type surfactant "Revon 15" (trade name, a product of Sanyo Chemical Industries Co., Ltd.). The suitable proportion of those nonionic or/and amphoteric surfactants in the photosensitive composition is from 0.05 to 15 % by weight, preferably from 0.1 to 5 % by weight.

To the photosensitive layer of the photosensitive lithographic printing plate of the present invention, dyes or fillers can be added as a print-out or image-coloring agent for obtaining visible images immediately after exposure. Examples of dyes usable in the present invention include the basic dyes disclosed in JP-A-5-313359, specifically the salts of cations having basic dye skeletons and organic anions which each have a sulfonic acid group alone as an individual exchanging group and contain at least 10 carbon atoms and 1 to 3 hydroxyl groups.

Such basic dyes can be added in a proportion of from 0.2 to 5 % by weight to the total ingredients in the photosensitive composition. Further, the compounds providing photolysis products which can interact with the dyes disclosed in JP-A-5-313359 described above to change their color tone can be added to the present photosensitive composition. Examples of such compounds include the o-naphthoquinonediazide-4-sulfonic acid halogenides disclosed in JP-A-50-36209 (corresponding to U.S. Patent 3,969,118), the trihalomethyl-2-pyrones and the trihalomethyltriazines disclosed in JP-A-53-36223 (corresponding to U.S. Patent 4,160,671), the o-naphthoquinonediazide compounds various in type as disclosed in JP-A-55-62444 (corresponding to U.S. Patent 2,038,801) and the 2-trihalomethyl-5-aryl-1,3,5-oxadiazole compounds disclosed in JP-A-55-77742 (corresponding to U.S. Patent 4,279,982). These compounds can be used alone or as a mixture of two or more thereof.

Dyes other than those disclosed in JP-A-5-31359 described above can also be used as a coloring agent for images. The dyes suitable as a coloring agent for images include not only salt-forming organic dyes but also oil-soluble dyes and basic dyes.

For instance, Oil Green BG, Oil Blue BOS, Oil Blue #603 (which are products of Orient Kagaku Kogyo K.K.), Victria Pure Blue BOH (a product of Hodogaya Chemical Co., Ltd.), Rhodamine B (CI45170B), Malachite Green (CI42000) and Methylene Blue (CI52015) can be suitably used as the coloring agent.

In preparing the photosensitive lithographic printing plate of the present invention, an aluminum sheet treated so as to have water receptivity, such as a silicate-treated aluminum sheet, an anodically oxidized aluminum sheet, a grained aluminum sheet or a silicate-electrodeposited aluminum sheet, can be used as its substrate. In addition, a zinc sheet, a stainless steel sheet, a chromatized steel sheet, a plastic sheet treated so as to have water receptivity and a paper sheet can also be used as the substrate.

Of these sheets, an aluminum sheet is preferred. The term "an aluminum sheet" used herein is intended to include a sheet of pure aluminum and sheets of aluminum alloys. Examples of usable aluminum alloy include alloys of aluminum and various metals, such as silicon, copper, manganese, magnesium, chromium, zinc, lead, bismuth and nickel. These alloy compositions contain negligibly small amounts of impurities in addition to some amounts of iron and titanium.

The aluminum sheet is subjected to surface treatment, if needed. Examples of suitable surface treatment include graining treatment, immersion treatment in a water solution of sodium silicate, potassium fluorozirconate or phosphate, and anodic oxidation treatment. Further, the aluminum sheet having undergone immersion treatment in a water solution of sodium silicate after graining treatment as disclosed in U.S. Patent 2,714,066, and the aluminum sheet having undergone immersion treatment in a water solution of alkali metal silicate after anodic oxidation treatment as disclosed in U. S. Patent 3,181,461 are also used to advantage. The anodic oxidation treatment as mentioned above can be effected by passing an electric current through an electrolytic solution in which an aluminum sheet is placed as anode. As examples of a usable electrolytic solution, mention may be made of an aqueous or non-aqueous solution of inorganic acid, such as phosphoric acid, chromic acid, sulfuric acid or boric acid, an aqueous or non-aqueous solution of organic acid, such as oxalic acid or sulfamic acid, or an aqueous or non-aqueous solution of salt of the acid as described above, and a mixture of two or more of the solutions described above.

In addition, the silicate electrodeposition as disclosed in U.S. Patent 3,658,662 is also effective.

The surface treatments recited above are carried out not only for imparting water receptivity to the substrate surface but also for preventing harmful reactions from occurring between the substrate and a photosensitive composition coated thereon and enhancing the adhesion between the substrate and the photosensitive layer.

Prior to the graining treatment, the aluminum sheet surface may be subjected to pretreatment for removing rolling oil and baring clean aluminum surface, if needed. For the former purpose, solvents, such as trichlene, and surfactants are employed; while, for the latter purpose, alkaline etching agents, such as sodium hydroxide and potassium hydroxide, are generally employed.

The graining treatment can be effected using any of mechanical, chemical and electrochemical methods. As the mechanical methods, there are well-known a ball abrasion method, a blast abrasion method and a brush abrasion method comprising rubbing an aqueous dispersion slurry of abrasive, such as pumice, with a nylon brush. As the chemical graining method, the method as disclosed in JP-A-54-31187, wherein the aluminun sheet is immersed in a saturated water solution of aluminum salt of mineral acid, is used to advantage. As the electrochemical graining method, the method of graining by application of AC to an acid electrolytic solution containing an acid, such as hydrochloric acid, nitric acid or a mixture thereof, is suitable. Of these graining methods, the combination of a mechanical graining method with an electrochemical graining method as disclosed in JP-A-55-137993 is preferred because it can provide strong adhesion between the substrate and the ink-receptive image.

It is effective to carry out the graining treatment using any of the aforementioned methods so that the aluminum sheet surface has a center line average roughness (Ra) in the range of 0.3 to 1.0 µm.

The thus grained aluminum sheet is washed and then chemically etched, if desired.

The solution for etching treatment is generally selected from aqueous solutions of bases or acids capable of dissolving aluminum. However, it is required for the etching solution not to form on the etched surface a film other than aluminum film. Examples of an etching agent satisfying such a requirement include basic substances, such as sodium hydroxide, potassium hydroxide, trisodium phosphate, disodium phosphate, tripotassium phosphate and dipotassium phosphate, and acidic substances such as sulfuric acid, persulfuric acid, phosphoric acid, hydrochloric acid and salts thereof. On the other hand, the salts of metals having ionization tendency weaker than aluminum, such as zinc, chromium, cobalt, nickel and copper, are undesirable because they form unnecessary films on the etched surface.

In the etching treatment, it is most desirable to determine the etching agent concentration and the temperature of the etching solution used so that the dissolution rate of aluminum or aluminum alloy used is in the range of 0.3 to 40 g/m² per one minute of immersion time. However, the dissolution rate may be below or above the foregoing range.

The etching treatment is carried out by immersing an aluminum sheet in the etching solution as described above or coating an aluminum sheet with the etching solution as described above, and the suitable amount of aluminum etched by this treatment is from 0.5 to 10 g/m².

Although the foregoing bases are preferred as etching agents because the aqueous solutions thereof have high etching rates, they bring about the generation of smut. Therefore, the aluminum sheet etched with an aqueous solution of base is generally subjected to desmut treatment. For the desmut treatment, nitric acid, sulfuric acid, phosphoric acid, chronic acid, hydrofluoric acid or borofluoric acid can be used.

The etched aluminum sheet is subjected to washing and anodic oxidation treatments, if neededd. The anodic oxidation treatment can be effected using any of conventional methods. More specifically, the aluminum substrate surface can be anodized by applying a direct or alternating current to the aluminum substrate in an aqueous or non-aqueous solution of sulfuric acid, phosphoric acid, chronic acid, oxalic acid, sulfamic acid or a mixture of two or more thereof.

The treatment conditions for anodic oxidation vary according to the electrolytic solution used, so they cannot be generalized. However, the following are practically appropriate conditions: The electrolyte concentration is from 1 to 80 % by weight, the solution temperature is from 5 to 70°C, the current density is 0.5 to 60 amperes/dm², the voltage is from 1 to 100 V, and the electrolysis time is from 0.5 to 50 minutes.

In particular, it is advantageous that the anodic oxidation is carried out using the method of applying a high current density to the aluminum substrate in sulfuric acid as disclosed in British Patent 1,412,768, or the method of using phosphoric acid as an electrolytic bath as disclosed in U.S. Patent 3,511,661.

The aluminum sheet grained and further anodized in the aforementioned manners may further undergo a treatment for rendering the sheet surface water-receptive, if desired. As a suitable method for this treatment, the method as disclosed in U.S. Patents 2,714,066 and 3,181,461, specifically the treatment with alkali metal silicates (e.g., an aqueous solution of sodium silicate), the method as disclosed in JP-A-36-22063, specifically the treatment with potassium fluorozirconate, and the method disclosed in U.S. Patent 4,153,461, specifically the treatment with polyvinylsulfonic acid, can be employed.

The aluminum sheet grained, anodized and further, if needed, rendered water-receptive may be coated with a subbing layer comprising a water-soluble compound. Water-soluble compounds usable for the subbing layer are those disclosed in JP-B-57-16349. Other compounds suitable for the subbing layer include the combination of a water-soluble metal salt and hydrophilic cellulose (such as the combination of zinc chloride and carboxymethyl cellulose, or the combination of magnesium chloride and hydroxyethyl cellulose), the polyacrylic amide disclosed in U.S. Patent 3,511,661, the polyvinylphosphonic acid disclosed in JP-A-46-35685, the amino acids and their salts disclosed in JP-A-60-149491 (such as alkali metal salts (e.g., sodium and potassium salts), ammonium salts, hydrochlorides, oxalates, acetates and phosphate of amino acids), and the hydroxyl group-containing amines and their salts disclosed in JP-A-60-232998. Of these compounds, the amino acid and their salt and the hydroxyl group-containing amine and their salts are preferred in particular. In forming a subbing layer, it is appropriate to coat the water-soluble compound as described above at a coverage of 1 to 80 mg/m² on a solids basis.

The compounds mentioned above as constituents of the present photosensitive composition are dissolved in an appropriate solvent, and then coated on the substrate as mentioned above to prepare a photosensitive lithographic printing plate. Examples of a solvent used herein include γ-butyrolactone, ethylene dichloride, cyclohexanone, methyl ethyl ketone, ethylene glycol monomethyl ether, ethylene glycol monoethyl ether, 2-methoxyethylacetate, 1-methoxy-2-propanol, 1-methoxy-2-propylacetate, toluene, ethyl acetate, methyl lactate, ethyl lactate, dimethyl sulfoxide, dimethylacetamide, dimethylformamide, water, N-methylpyrrolidone, tetrahydro-furfuryl alcohol, acetone, diacetone alcohol, methanol, ethanol, isopropanol and diethylene glycol dimethyl ether. These solvents can be used alone or as a mixture of two or more thereof. The suitable concentration of constituents (solids) in the coating solution is from 5 to 50 % by weight. The suitable coverage of the present photosensitive composition is generally from 0.5 to 3.0 g/m² on a solids basis. Although the decrease in coverage of the photosensitive composition brings about an increase in photosensitivity, the physical properties of the photosensitive film formed become poor.

To the photosensitive layer of the photosensitive lithographic printing plate of the present invention, surfactants for improving coatability, e.g., the fluorine-containing surfactants disclosed in JP-A-62-170950, can be added. It is effective to add such surfactants in a proportion of 0.01 to 1 % by weight, preferably 0.05 to 0.5 % by weight. The surface of the photosensitive layer formed in the foregoing manner is preferably matted for the purpose of shortening the evacuation time upon contact exposure using a vacuum flame and preventing the printed image from blurring. As examples of a method for rendering the photosensitive layer surface matte, mention may be made of the methods of providing the matte layers disclosed in JP-A-50-125805, JP-B-57-6582 and JP-B-61-28986 respectively, and the method of heat-fusing solid particles to the layer surface as disclosed in JP-B-62-62337.

The developers suitable for the photosensitive lithographic printing plate of the present invention are aqueous alkaline solutions containing substantially no organic solvents, with examples including aqueous solutions of sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium carbonate, sodium hydrogen carbonate, potassium carbonate and potassium hydrogen carbonate, and aqueous ammonia. The suitable concentration of these solutions is within the range of 0.1 to 10 weight %, preferably 0.5 to 5 weight %. Of those developers, the developers containing alkali silicates, such as potassium silicate, lithium silicate and sodium silicate, are preferred over the others because it becomes hard for the printing plates processed therewith to occur scum. As to the composition of alkali silicates contained in the developer, the [SiO₂]/[M] ratio is in the range of 0.5 to 2.5 by mole (wherein [SiO₂] means a molar concentration of SiO₂ and [M] means a molar concentration of the total alkali metals), and the developers having their SiO₂ concentrations in the range of 0.8 to 8 weight % are used to advantage. To such a developer may be added water-soluble sulfites, such as sodium sulfite, potassium sulfite and magensium sulfite, resorcin, methylresorcin, hydroquinone and thiosalycilic acid. The suitable proportion of these additives in the developer is from 0.002 to 4 % by weight, preferably from 0.01 to 1 % by weight.

By further containing in the developer the anionic surfactants and the amphoteric surfactants as disclosed in JP-A-50-51324 and JP-A-59-84241, at least one of the nonionic surfactants as disclosed in JP-A-59-75255, JP-A-60-11246 and JP-A-60-213943, or the polyelectrolytes as disclosed in JP-A-55-95946 and JP-A-56-142528, the developer can be enhanced in wettability of the photosensitive composition and stability of development (development latitude). The suitable concentration of those surfactants in the developer is from 0.001 to 2 weight %, particularly preferably from 0.003 to 0.5 weight %. In addition, it is advantageous that the proportion of potassium to the total alkali metals of alkali silicates contained in the developer be at least 20 mole %, preferably at least 90 mole %, and particularly preferably 100 mole %, because the generation of insoluble matter in the developer can be reduced.

To the developers used in the present invention, a small amount of organic solvent such as alcohol, the chelating agents disclosed in JP-A-58-190952, the metal salts disclosed in JP-B-1-30139 and antifoaming agents such as organosilane compounds can furthermore added.

As a light source for exposure, a carbon arc lamp, a mercury lamp, a xenon lamp, a tungsten lamp and a metal halide lamp can be employed.

Needless to say, the photosensitive lithographic printing plates as mentioned above may be subjected to plate-making treatment according to any of the methods disclosed in JP-A-54-8002, JP-A-55-115045 and JP-A-59-58431. More specifically, the developed photosensitive lithographic printing plate may be subjected to desensitizing treatment after or without washing, or may be processed with an aqueous solution containing an acid, or may be subjected to desensitizing treatment after treatment with an aqueous solution containing an acid. Since the aqueous alkali solution is consumed in proportion to the processing throughput in the development step to decrease its alkali concentration, or the alkali concentration is lowered by exposure to air during the long-term continuous operation of an automatic processor, the developer suffers form the lowering of processing ability. Under these circumstances, the processing ability may be regained by using a replenisher as disclosed in JP-A-54-62004. In this case, the replenishment is advantageously performed according to the method disclosed in U.S. Patent 4,882,246. Additionally, the plate-making treatment is advantageously effected using the automatic processor as disclosed in JP-A-2-7054 or JP-A-2-32357.

In the case where the deletion of unnecessary image areas is carried out after the present photosensitive lithographic printing plate is subjected sequentially to imagewise exposure, development and washing or rinsing, the delation fluid as disclosed in JP-B-2-13293 is used to advantage. On an occasion when the photosensitive lithographic printing plate of the present invention is coated with desensitizing gum at the final step of plate-making process, the desensitizing gum as disclosed in JP-B-62-16834, JP-B-62-25118, JP-B-63-52600, JP-A-62-7595, JP-A-62-11693 or JP-A-62-83194 can be favorably employed.

In the other case where the photosensitive lithographic printing plate of the present invention undergoes burning-in treatment after it is subjected sequentially to imagewise exposure, development and washing or rinsing, and further, if desired, deletion and washing, it is beneficial that the treatment with the burning conditioner as disclosed in JP-B-61-2518, JP-B-55-28062, JP-A-62-31859 or JP-A-61-159655 is carried out before the burning-in treatment.

### EXAMPLE

Now, the present invention is illustrated in more detail by reference to the following Synthesis Examples and Examples, but these examples should not be construed as limiting on or determinative of the scope of the present invention.

### EXAMPLE I

### Synthesis Example I-1:

In a 1 liter three-necked flask equipped with a stirrer and a condenser, 62.1 g (0.5 mole) of 4-hydroxybenzyl alcohol, 77.6 g (0.5 mole) of methacryloyloxyethylisocyanate, 0.04 g (0.3 mmole) of p-methoxyphenol, 0.2 g (0.3 mmole) of di-n-butyltin dilaurate and 700 ml of acetone were placed, and stirred to make a solution. Further, the stirring was continued for 8 hours while heating the solution at 50°C by means of an oil bath. At the conclusion of the reaction, the reaction mixture was poured into 3 liter of water with stirring, and further stirred for 30 minutes, followed by filtration. Thus, 55.9 g of Compound M1 was obtained.

The thus obtained Compound M1 in an amount of 4.19 g (0.015 mole), 1.30 g (0.01 mole) of 2-hydroxyethyl methacrylate, 1.50 g (0.015 mole) of methyl methacrylate, 3.18 g (0.06 mole) of acrylonitrile and 20 g of N,N-dimethylacetamide were placed in a 200 ml three-necked flask equipped with a stirrer and a dropping funnel, and stirred while heating at 65°C by means of a hot water bath. Thereto, 0.25 g of a polymerization initiator V-65 (trade name, a product of Wako Pure Chemical Industries, Ltd.) was added, and stirred for 2 hours in a stream of nitrogen as the temperature was kept at 65°C. To the resulting reaction mixture, a mixture of 4.19 g of Compound M1, 1.30 g of 2-hydroxyethyl methacrylate, 1.50 g of methyl methacrylate, 3.18 g of acrylonitrile, 20 g of N,N-dimethylacetamide and 0.25 g of V-65 was further added dropwise from the dropping funnel over a 2-hour period. After the conclusion of dropwise addition, the mixture was further stirred for 2 hours at 65°C. At the conclusion of the reaction, 40 g of methanol was added, cooled, and poured into 2 liter of water with stirring. After stirring for additional 30 minutes, the reaction mixture was filtered off, and dried to yield 18 g of white solid. By gel permeation chromatography, it was confirmed that the thus produced high molecular compound (referred to as the present high molecular Compound (a), which is shown in Table I-1) had a weight average molecular weight of 52,000 (by the polystyrene standard).

### Synthesis Example I-2:

High molecular Compounds (b) to (h) shown in Table I-1 were synthesized in the same manner as in Synthesis Example I-1.

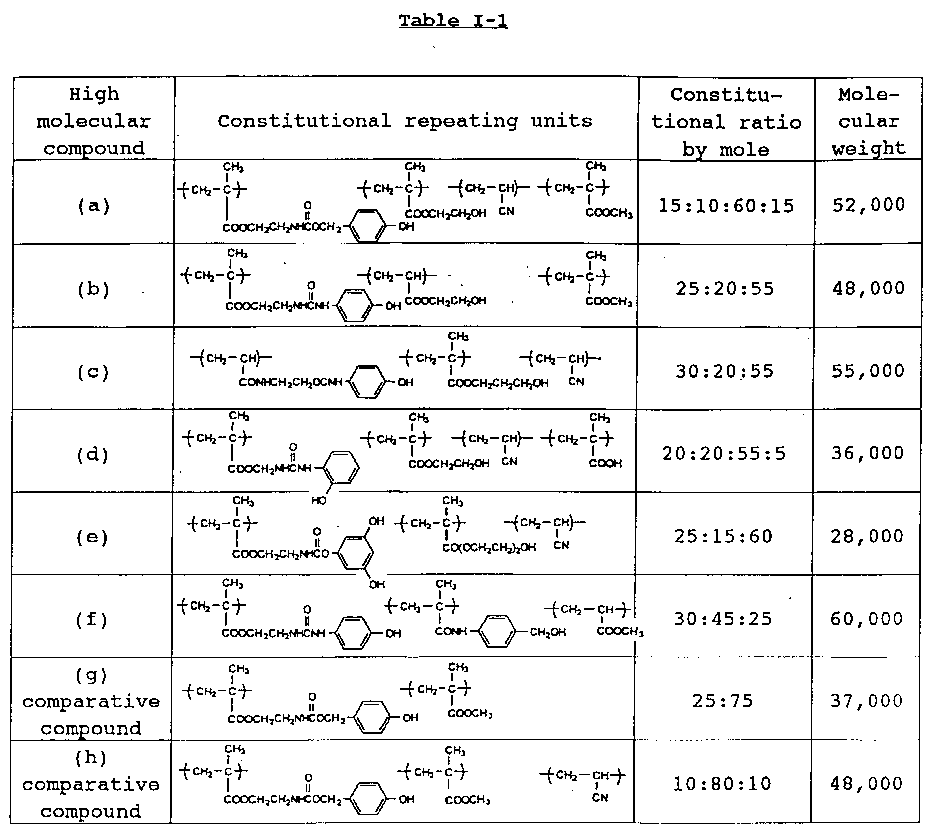

The present invention, is further illustrated by the following examples of preferred embodiments thereof. Additionally, "%" in the following examples and comparative examples is "% by weight" unless otherwise noted.

### EXAMPLES I-1 TO I-9 AND COMPARATIVE EXAMPLES I-1 TO I-3

A 0.30 mm-thick aluminum sheet surface was grained using a nylon brush and a 400-mesh pumice stone-water suspension, and washed thoroughly with water. This sheet was etched by 60-second immersion in a 10 % aqueous solution of sodium hydroxide kept at 70°C, washed with running water, rinsed with 20 % HNO₃ for neutralization, and further washed with water. Then, the thus etched sheet underwent electrolytic treatment for roughening the surface thereof, wherein a 1 % aqueous solution of nitric acid was used as an electrolyte and an alternating current of sine-wave form was applied under the condition of V_{A} = 12.7 V so that the quantity of electricity at the anode was 160 Coulomb/dm². The surface roughness measurement showed that the thus treated sheet had a surface roughness of 0.6 µ, expressed in terms of Ra. Successively thereto, the aluminum sheet was desmutted by 2-minute immersion in a 30 % aqueous solution of H₂SO₄ kept at 55°C, and further anodized in a 20 % aqueous solution of H₂SO₄ under the condition of a current density of 2 A/dm² till the anodic film had a thickness of 2.7 g/m². Thus, the substrate was prepared.

On the surface of the substrate treated in the foregoing manner, a subbing layer composition (A) constituted of the following ingredients was coated, and dried at 80°C for 30 seconds. The dry coverage thereof was 30 mg/m².

### Subbing layer composition (A):

| | |
|---|---|
| Aminoethylphosphonic acid | 0.10 g |
| Phenylphosphonic acid | 0.15 g |
| Triethanolamine | 0.05 g |
| β-Alanine | 0.10 g |
| Methanol | 40 g |
| Purified water | 60 g |

The thus treated substrate is referred to as Substrate (I).

On the Substrate (I), the compositions categorized below as Photosensitive Composition (B) were each coated at a coverage of 25 ml/m² by means of a rod coater, and then dried at 100°C for 1 minute to prepare positive-working photosensitive lithographic printing plates [B]-1 to [B]-8. In addition, the compositions categorized below as Photosensitive Composition (C) were prepared, coated and dried in the same manners as the foregoing Photosensitive Composition (B) to prepare positive-working photosensitive lithographic printing plates [C]-1 to [C]-4 respectively. The dry coverage of each composition was about 1.7 g/m².

Additionally, the present or comparative high molecular compounds used in the photosensitive lithographic printing plates [B]-1 to [B]-8 and [C]-1 to [C]-4 are those shown in Table I-1.

### Photosensitive Composition (B):

| | |
|---|---|
| Esterification product of 2,3,4-tri-hydroxybenzophenone and naphthoquinone-1,2-diazide-5-sulfonyl chloride (esterification degree: 90 mole %) | 0.45 g |
| Cresol-formaldehyde novolak resin (meta/para ratio: 6/4, weight average molecular weight: 3,000, number average molecular weight: 1,100, unreacted cresol content: 0.7 %) | 0.2 g |
| m-Cresol-formaldehyde novolak resin (weight average molecular weight: 1,700, number average molecular weight: 600, unreacted cresol content: 1 %) | 0.3 g |
| Condensation product of pyrogallol and acetone (weight average molecular weight: 2,200, number average molecular weight: 700) | 0.1 g |
| Present high molecular compound (or comparative high molecular compound) | 1.1 g |
| p-n-Octylphenol-formaldehyde resin (disclosed in U.S. Patent 4,123,279) | 0.02 g |
| Naphthoquinonediazide-1,2-diazide-4-sulfonic acid chloride | 0.01 g |
| Tetrahydrophthalic anhydride | 0.02 g |
| Benzoic acid | 0.02 g |
| 4-[p-N-(p-Hydroxybenzoyl)aminophenyl]-2,6-bis(trichloromethyl)-s-triazine | 0.02 g |
| N-(1,2-Naphthoquinone-2-diazide-4-sulfonyloxy)-cyclohexane-1,2-dicarboxylic acid imide | 0.01 g |
| Curcumin, a dye obtained by converting the counter anion of Victoria Pure Blue BOH (produced by Hodogaya Chemical Co., Ltd.) into 1-naphthalenesulfonic acid | 0.005 g |
| 1-[α-Methyl-α-(4-hydroxy-3,5-dihydroxymethylphenyl)ethyl]-4-[α,α-bis-(4-hydroxy-3,5-dihydroxymethylphenyl)ethyl]benzene (Compound (X) disclosed in JP-A-6-282067) | 0.04 g |
| Megafac F-176 (fluorine-containing surfactant produced by Dai-Nippon Ink & Chemicals Inc.) | 0.01 g |
| Methyl ethyl ketone | 10 g |
| γ-Butyrolactone | 5 g |
| 1-Methoxy-2-propanol | 5 g |

### Photosensitive Composition (C):

| | |
|---|---|
| Esterification product of 2,3,4-tri-hydroxybenzophenone and naphthoquinone-1,2-diazide-5-sulfonyl chloride (esterification degree: 90 mole %) | 0.45 g |
| Present high molecular compound (or comparative high moelcular compound) | 1.7 g |
| p-n-Octylphenol-formaldehyde resin (disclosed in U.S. Patent 4,123,279) | 0.02 g |
| Naphthoquinonediazide-1,2-diazide-4-sulfonic acid chloride | 0.01 g |
| Tetrahydrophthalic anhydride | 0.02 g |
| Benzoic acid | 0.02 g |
| 4-[p-N-(p-Hydroxybenzoyl)aminophenyl]-2,6-bis(trichloromethyl)-s-triazine | 0.02 g |
| N-(1,2-Naphthoquinone-2-diazide-4-sulfonyloxy)-cyclohexane-1,2-dicarboxylic acid imide | 0.01 g |
| Curcumin, a dye obtained by converting the counter anion of Victoria Pure Blue BOH (produced by Hodogaya Chemical Co., Ltd.) into 1-naphthalenesulfonic acid | 0.005 g |
| 1-[α-Methyl-α-(4-hydroxy-3,5-dihydroxymethylphenyl)ethyl]-4-[α,α-bis(4-hydroxy-3,5-dihydroxymethylphenyl)ethyl]benzene (Compound (X) disclosed in JP-A-6-282067) | 0.04 g |
| Megafac F-176 (fluorine-containing surfactant produced by Dai-Nippon Ink & Chemicals Inc.) | 0.01 g |
| Methyl ethyl ketone | 10 g |
| γ-Butyrolactone | 5 g |
| 1-Methoxy-2-propanol | 5 g |

A transparent positive original having line and halftone images was brought into close contact with the photosensitive layer of each of the photosensitive lithographic printing plates [B]-1 to [B]-8 and [C]-1 to [C]-4, and exposed by means of a carbon arc lamp of 30 ampere placed at a distance of 70 cm.

Each of the exposed photosensitive lithographic printing plates [B]-1 to [B]-8 and [C]-1 to [C]-4 was developed by 60-second immersion at 25°C in an aqueous solution (diluted to 8 times) of DP-4 (trade name, a product of Fuji Photo Film Co., Ltd.). Each of the thus obtained lithographic printing plates [B]-1 to [B]-8 and [C]-1 to [C]-4 was loaded in a printing press "Model KOR" made by Heidelberg A.G., and therefrom the line and halftone images were printed on woodfree paper sheets using commercially available ordinary ink or UV ink. By these operations, each printing plate was examined for number of prints (i.e., printed matters) produced therefrom and scumming generated till the final printing was done. The results obtained are shown in Table I-2.

As can be seen from Table 1-2, each of the lithographic printing plates [B]-1 to [B]-6 and [C]-1 to [C]-3 using the present high molecular compounds (Examples I-1 to I-6 and Examples I-7 to I-9) provided a great number of prints in both cases of using ordinary ink and UV ink, compared with each of the lithographic printing plates [B]-7 and [B]-8 and [C]-4 (Comparative Examples I-1, I-2 and I-3), namely the printing plate of the present inventions were superior in press life to the comparative ones. Further, the printing plate of the present inventions were superior in anti-scumming properties also to the comparative printing plates.

**Table I-2**

| Lithographic printing plate | High molecular compound used | Number of prints produced with ordinary ink | Number of prints produced with UV ink | Anti-scumming properties* |
|---|---|---|---|---|
| [B]-1 Example I-1 | (a) | 65,000 | 40,000 | ○ |
| [B]-2 Example I-2 | (b) | 65,000 | 40,000 | ○ |
| [B]-3 Example I-3 | (c) | 60,000 | 30,000 | ○ |
| [B]-4 Example I-4 | (d) | 65,000 | 40,000 | ○ |
| [B]-5 Example I-5 | (e) | 60,000 | 35,000 | ○ |
| [B]-6 Example I-6 | (f) | 58,000 | 28,000 | ○ |
| [B]-7 Comparative Example I-1 | (g) | 36,000 | 12,000 | X |
| [B]-8 Comparative Example I-2 | (h) | 28,000 | 8,000 | ○ |
| [C]-1 Example I-7 | (a) | 78,000 | 62,000 | ○ |
| [C]-2 Example I-8 | (b) | 76,000 | 58,000 | ○ |
| [C]-3 Example I-9 | (f) | 68,000 | 56,000 | ○ |
| [C]-4 Comparative Example I-3 | (h) | 36,000 | 14,000 | X |

| | | | | |
|---|---|---|---|---|
| * visual evaluation ○: good, X: very bad | | | | |

### EXAMPLE II

### Synthesis Example II-1:

In a 200 ml three-necked flask equipped with a stirrer, a condenser and a dropping funnel, 3.60 g (0.015 mole) of N-(p-aminosulfonylphenyl)methacrylamide, 1.30 g (0.01 mole) of 2-hydroxyethyl methacrylate, 1.50 g (0.015 mole) of methyl methacrylate, 3.18 g (0.06 mole) of acrylonitrile and 20 g of N,N-dimethylacetamide were placed and stirred while heating at 65°C by means of a hot water bath. Thereto, 0.25 g of a polymerization initiator V-65 (trade name, a product of Wako Pure Chemical Industries, Ltd.) was added, and stirred for 2 hours in a stream of nitrogen as the temperature was kept at 65°C. To the resulting reaction mixture, a mixture of 3.60 g of N-(p-aminosulfonylphenyl)methacrylamide, 1.30 g of 2-hydroxyethyl methacrylate, 1.50 g of methyl methacrylate, 3.18 g of acrylonitrile, 20 g of N,N-dimethylacetamide and 0.25 g of V-65 was further added dropwise from the dropping funnel over a 2-hour period. After the conclusion of dropwise addition, the mixture was further stirred for 2 hours at 65°C. At the conclusion of the reaction, 40 g of methanol was added, cooled, and poured into 2 liter of water with stirring. After stirring for additional 30 minutes, the reaction mixture was filtered off, and dried to yield 18 g of white solid. By gel permeation chromatography, it was confirmed that the thus produced high molecular compound (referred to as the present high molecular Compound (a'), which is shown in Table II-1) had a weight average molecular weight of 45,000 (by the polystyrene standard).

### Synthesis Examples II-2 to II-7:

High molecular Compounds (b') to (i') shown in Table II-1 were synthesized in the same manner as in Synthesis Example II-1.

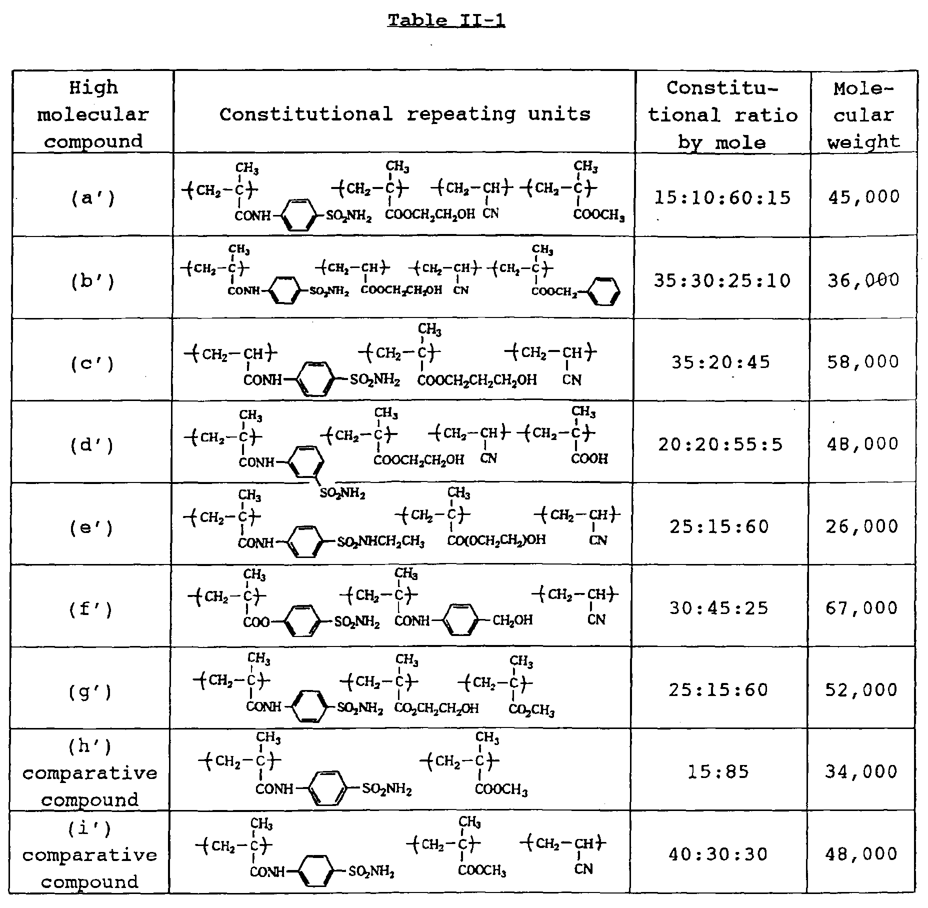

The present invention is further illustrated by the following examples of preferred embodiments thereof. Additionally, "%" in the following examples and comparative examples is "% by weight" unless otherwise noted.

### EXAMPLES II-1 TO II-10 AND COMPARATIVE EXAMPLES II-1 TO II-3

A 0.30 mm-thick aluminum sheet surface was grained using a nylon brush and a 400-mesh pumice stone-water suspension, and washed thoroughly with water. This sheet was etched by 60-second immersion in a 10 % aqueous solution of sodium hydroxide kept at 70°C, washed with running water, rinsed with 20 % HNO₃ for neutralization, and further washed with water. Then, the thus etched sheet underwent electrolytic treatment for roughening the surface thereof, wherein a 1 % aqueous solution of nitric acid was used as an electrolyte and an alternating current of sine-wave form was applied under the condition of V_{A} = 12.7 V so that the quantity of electricity at the anode was 160 Coulomb/dm². The surface roughness measurement showed that the thus treated sheet had a surface roughness of 0.6 µ, expressed in terms of Ra. Successively thereto, the aluminum sheet was desmutted by 2-minute immersion in a 30 % aqueous solution of H₂SO₄ kept at 55°C, and further anodized in a 20 % aqueous solution of H₂SO₄ under the condition of a current density of 2 A/dm² till the anodic coating had a thickness of 2.7 g/m². Thus, the substrate was prepared.

On the surface of the substrate treated in the foregoing manner, a subbing layer composition (A) constituted of the following ingredients was coated, and dried at 80°C for 30 seconds. The dry coverage thereof was 30 mg/m².

### Subbing layer composition (A):

| | |
|---|---|
| Aminoethylphosphonic acid | 0.10 g |
| Phenylphosphonic acid | 0.15 g |
| Triethanolamine | 0.05 g |
| β-Alanine | 0.10 g |
| Methanol | 40 g |
| Purified water | 60 g |

The thus treated substrate is referred to as Substrate (I)

On the Substrate (I), the compositions categorized below as Photosensitive Composition (B') were each coated at a coverage of 25 ml/m² by means of a rod coater, and then dried at 100°C for 1 minute to prepare positive-working photosensitive lithographic printing plates [B']-1 to [B']-9. In addition, the compositions categorized below as Photosensitive Composition (C') were prepared, coated and dried in the same manners as the foregoing Photosensitive Composition (B') to prepare positive-working photosensitive lithographic printing plates [C']-1 to [C']-4 respectively. The dry coverage of each composition was about 1.7 g/m².

Additionally, the present or comparative high molecular compounds used in the photosensitive lithographic printing plates [B']-1 to [B']-9 and [C']-1 to [C']-4 are those shown in Table II-1.

### Photosensitive Composition (B'):

| | |
|---|---|
| Esterification product of 2,3,4-trihydroxybenzophenone and naphthoquinone-1,2-diazide-5-sulfonyl chloride (esterification degree: 90 mole %) | 0.45 g |
| Cresol-formaldehyde novolak resin (meta/para ratio: 6/4, weight average molecular weight: 3,000, number average molecular weight: 1,100, unreacted cresol content: 0.7 %) | 0.2 g |
| m-Cresol-formaldehyde novolak resin (weight average molecular weight: 1,700, number average molecular weight: 600, unreacted cresol content: 1 %) | 0.3 g |
| Condensation product of pyrogallol and acetone (weight average molecular weight 2,200, number average molecular weight: 700) | 0.1 g |
| Present high molecular compound (or comparative high molecular compound) | 1.1 g |
| p-n-Octylphenol-formaldehyde resin (disclosed in U.S. Patent 4,123,279) | 0.02 g |
| Naphthoquinonediazide-1,2-diazide-4-sulfonic acid chloride | 0.01 g |
| Tetrahydrophthalic anhydride | 0.02 g |
| Benzoic acid | 0.02 g |
| 4-[p-N-(p-Hydroxybenzoyl)aminophenyl]-2,6-bis(trichloromethyl)-s-triazine | 0.02 g |
| N-(1,2-Naphthoquinone-2-azide-4-sulfonyloxy)-cyclohexane-1,2-dicarboxylic acid imide | 0.01 g |
| Curcumin, a dye obtained by converting the counter anion of Victoria Pure Blue BOH (produced by Hodogaya Chemical Co., Ltd.) into 1-naphthalenesulfonic acid | 0.005 g |
| 1-[α-Methyl-α-(4-hydroxy-3,5-dihydroxymethylphenyl)ethyl]-4-[α,α-bis(4-hydroxy-3,5-dihydroxymethylphenyl)ethyl]benzene (Compound (X) disclosed in JP-A-6-282067) | 0.04 g |
| Megafac F-176 (fluorine-containing surfactant produced by Dai-Nippon Ink & Chemicals Inc.) | 0.01 g |
| Methyl ethyl ketone | 10 g |
| γ-Butyrolactone | 5 g |
| 1-Methoxy-2-propanol | 5 g |

### Photosensitive Composition (C'):

| | |
|---|---|
| Esterification product of 2,3,4-trihydroxybenzophenone and naphthoquinone-1,2-diazide-5-sulfonyl chloride (esterification degree: 90 mole %) | 0.45 g |
| Present high molecular compound (or comparative high moelcular compound) | 1.7 g |
| p-n-Octylphenol-formaldehyde resin (disclosed in U.S. Patent 4,123,279) | 0.02 g |
| Naphthoquinonediazide-1,2-diazode-4-sulfonic acid chloride | 0.01 g |
| Tetrahydrophthalic anhydride | 0.02 g |
| Benzoic acid | 0.02 g |
| 4-[p-N-(p-Hydroxybenzoyl)aminophenyl]-2,6-bis(trichloromethyl)-s-triazine | 0.02 g |
| N-(1,2-Naphthoquinone-2-diazide-4-sulfonyloxy)-cyclohexane-1,2-dicarboxylic acid imide | 0.01 g |
| Curcumin, a dye obtained by converting the counter anion of Victoria Pure Blue BOH (produced by Hodogaya Chemical Co., Ltd.) into 1-naphthalenesulfonic acid | 0.005 g |
| 1-[α-Methyl-α-(4-hydroxy-3,5-dihydroxymethylphenyl)ethyl]-4-[α,α-bis(4-hydroxy-3,5-dihydroxymethylphenyl)ethyl]benzene (Compound (X) disclosed in JP-A-6-282067) | 0.04 g |
| Megafac F-176 (fluorine-containing surfactant produced by Dai-Nippon Ink & Chemicals Inc.) | 0.01 g |
| Methyl ethyl ketone | 10 g |
| γ-Butyrolactone | 5 g |
| 1-Methoxy-2-propanol | 5 g |

A transparent positive original having line and halftone images was brought into close contact with the photosensitive layer of each of the photosensitive lithographic printing plates [B']-1 to [B']-9 and [C']-1 to [C']-4, and exposed by means of a carbon arc lamp of 30 ampere placed at a distance of 70 cm.

Each of the exposed photosensitive lithographic printing plates [B']-1 to [B']-9 and [C']-1 to [C']-4 was developed by 60-second immersion at 25°C in an aqueous solution (diluted to 8 times) of DP-4 (trade name, a product of Fuji Photo Film Co., Ltd.). Each of the thus obtained lithographic printing plates [B']-1 to [B']-9 and [C']-1 to [C']-4 was loaded in a printing press "Model KOR" made by Heidelberg A.G., and therefrom the line and halftone images were printed on woodfree paper sheets using commercially available ordinary ink or UV ink. By these operations, each printing plate was examined for number of prints (i.e., printed matters) produced therefrom and scumming generated till the final printing was done. The results obtained are shown in Table II-2.

As can be seen from Table II-2, each of the lithographic printing plates [B']-1 to [B']-7 and [C']-1 to [C']-3 using the present high molecular compounds (Examples II-1 to II-7 and Examples II-8 to II-10) provided a great number of prints in both cases of using ordinary ink and UV ink, compated with each of the lithographic printing plates [B']-8 and [B']-9 and [C']-4 (Comparative Examples II-1, II-2 and II-3), namely the printing plate of the present inventions were superior in press life to the comparative ones. Further, the printing plate of the present inventions were superior in anti-scumming properties also to the comparative printing plates.

**Table II-2**

| Lithographic printing plate | High molecular compound used | Number of prints produced with ordinary ink | Number of prints produced with UV ink | Antiscumming properties* |
|---|---|---|---|---|
| [B']-1 Example II-1 | (a') | 68,000 | 45,000 | ○ |
| [B']-2 Example II-2 | (b') | 65,000 | 40,000 | ○ |
| [B']-3 Example II-3 | (c') | 60,000 | 30,000 | ○ |
| [B']-4 Example II-4 | (d') | 65,000 | 40,000 | ○ |
| [B']-5 Example II-5 | (e') | 60,000 | 35,000 | ○ |
| [B']-6 Example II-6 | (f') | 58,000 | 28,000 | ○ |
| [B']-7 Example II-7 | (g') | 60,000 | 32,000 | ○ |
| [B']-8 Comparative Example II-1 | (h) | 35,000 | 18,000 | X |
| [B']-9 Comparative Example II-2 | (i') | 40,000 | 12,000 | ○ |
| [C']-1 Example II-8 | (a') | 83,000 | 64,000 | ○ |
| [C']-2 Example II-9 | (c') | 78,000 | 52,000 | ○ |
| [C']-3 Example II-10 | (g') | 76,000 | 56,000 | ○ |
| [C']-4 Comparative Example II-3 | (i') | 42,000 | 23,000 | X |

| | | | | |
|---|---|---|---|---|
| * visual evaluation ○ : good, X : very bad | | | | |

### EFFECT OF THE INVENTION

As the photosensitive lithographic printing plate of the present invention contains in its photosensitive layer a specific copolymer comprising units of a monomer (A) and units of a monomer (B), the photosensitive layer can have good adhesiveness to a substrate, satisfactory pliability and high solubilities in organic solvents. As a result, the photosensitive layer of the present invention has good suitability for coating on a substrate, and the exposed area thereof after coating, drying and imagewise-exposure can be developed effectively with an aqueous alkali developer. The relief images formed therein have high abrasion resistance and high adhesiveness to the substrate, so that when they are utilized as a printing plate a great number of prints of good quality can be obtained.

Further, the present photosensitive layer has excellent chemical resistance, and so it can provide a great number of prints of good quality even when it is subjected to the printing with UV ink without undergoing burning-in treatment. In other words, the photosensitive lithographic printing plate of the prersent invention can provide a lithographic printing plate having excellent press life and generatinging no scum.

## Claims

1. A photosensitive lithographic printing plate having a photosensitive layer that comprises an o-naphthoquinone diazide compound and a vinyl polymer insoluble in water but soluble in an alkaline aqueous solution, wherein said vinyl polymer is a copolymer that comprises (A) units of a compound containing at least one phenolic hydroxyl group or at least one sulfonamido group and at least one polymerizable unsaturated bond and (B) units of a compound containing at least one alcoholic hydroxyl group and at least one polymerizable unsaturated bond.

2. A photosensitive lithographic printing plate as in claim 1, wherein said copolymer comprises (A) units of a compound containing at least one phenolic hydroxyl group or at least one sulfonamido group and at least one polymerizable unsaturated bond in a proportion of from 1 to 40 mole % in one molecule of the copolymer.

3. A photosensitive lithographic printing plate as in claim 1, wherein said copolymer comprises (B) units of a compound containing at least one alcoholic hydroxyl group and at least one polymerizable unsaturated bond in a proportion of from 1 to 50 mole % in one molecule of the copolymer.
